# EUROPÄISCHE PATENTSCHRIFT

(11) **EP 0 534 047 B1**
(45) Veröffentlichungstag und Bekanntmachung des Hinweises auf die Patenterteilung: **21.09.1994**
(21) Anmeldenummer: 92103427.8
(22) Anmeldetag: 28.02.1992
(51) Int. Cl.: C23C 14/56, C23C 14/22, B01J 3/00

(54) **Vorrichtung zur Reduzierung der Durchbiegung von Aussenwänden an Vakuumbehältern**
Apparatus for the reduction of deformation of the exterior walls of vacuum chambers
Dispositif pour réduire la déformation des parois externes des chambres à vide

(30) Priorität: 27.09.1991 DE 4132204
(43) Veröffentlichungstag der Anmeldung: 31.03.1993
(73) Patentinhaber: LEYBOLD AKTIENGESELLSCHAFT, D-63450 Hanau (DE)
(72) Erfinder: Pawlakowitsch, Anton, Dr., W-8752 Mömbris (DE); Schönherr, Bernhard, Dipl.-Ing., W-6050 Offenbach am Main (DE)

(56) Entgegenhaltungen:
- EP-A- 0 374 060
- WO-A-82/02246
- US-A- 4 014 779

## Beschreibung

Die Erfindung betrifft eine Vorrichtung zur Reduzierung der Durchbiegung von im wesentlichen ebenen Außenwänden an Vakuumbehältern, insbesondere an Vakuum-Bandbeschichtungsanlagen, und zur Vermeidung von daraus resultierenden Veschiebungen von, an diesen Außenwänden befestigten Bauelementen, wie beispielsweise Umlenkwalzen einer Wickelvorrichtung.

Bei Vakuumbehältern besteht generell die Gefahr der Verformung und speziell der Durchbiegung der Behälterwände durch die unterschiedlichsten Druckverhältnisse auf beiden Seiten der Außenwände. Dies gilt für die unterschiedlichsten Größen und geometrischen Formen von Behältern.

Im Stand der Technik ist beispielsweise eine Schrift bekannt (WO82/02246), welche eine Vorrichtung zur Reduzierung der Durchbiegung von im wesentlichen ebenen Außenwänden an einer zylindrischen drehbaren Vakuumkammer offenbart. Dies wird mittels eines zweiteiligen Distanzbolzens erreicht, welcher zusätzlich auch eine Rotationsachse bildet und zwischen zwei gegenüberliegenden Außenwänden vorgesehen ist.

Bei einem Großteil aller Vakuumbehälter sind Verformungen der oben genannten Art von untergeordneter Bedeutung und können toleriert werden. Es gibt jedoch auch Anwendungen, beispielsweise in der Vakuum-Bandbeschichtung, für die eine Durchbiegung der Behälter unerwünscht bzw. unzulässig ist. Bandbeschichtungsanlagen bestehen in der Regel aus einem feststehenden Vakuumkessel mit einer beweglichen Außenwand, der sogenannten Rezipientenplatte. An dieser Platte ist ein Wickelsystem zur Führung des zu beschichtenden Bandes befestigt. Dieses Wikkelsystem besteht aus mehreren, parallel zueinander angeordneten Führungs- und Umlenkwalzen, welche zwischen der Rezipientenplatte und einer Gegenplatte gelagert sind. Aufgrund der extrem geringen Dicke des zu beschichtenden Bandes bzw. der Folie und der hohen Durchlaufgeschwindigkeit der Folie in der Anlage sind die maßlichen Anforderungen an die Parallelität der Walzen sehr hoch. Schon eine geringe Winkelabweichung macht die eingesetzte Folie unbrauchbar.

Während des Beschichtungsbetriebes, d.h. in dem Kessel herrscht Vakuum, kommt es durch den auf der Außenseite der Rezipientenplatte lastenden Atmosphärendruck zu einer Durchbiegung der Rezipientenplatte. Da die Gegenplatte weitgehend frei von äußeren Kräften ist, kommt es je nach Ausführungsform und Lagerungsart der Walzen zu einer Unparallelität der Walzen.

Diese nachteiligen Maßabweichungen der Parallelität der Umlenk- und Führungswalzen können zum einen durch aufwendigere Bauformen der Walzen umgangen werden. So werden z.B. die Achsen der Walzenkörper durchgehend ausgeführt, was die Möglichkeit eröffnet, durch einen Loslagersitz an der Rezipientenplattenseite die Bewegung der Wand weitgehend von der Walzenachse zu entkoppeln. Nachteilig sind hierbei der größere Materialeinsatz sowie die niedrige Eigenfrequenz für Biegeschwingungen der langen Achse.

Eine weitere Möglichkeit, die Durchbiegung der Rezipientenplatte zu verringern, bzw. zu vermeiden, ist das Anbringen biegesteifer Profile als Verstärkung auf der Plattenaußenseite. Dies hat jedoch erhebliche fertigungstechnische Nachteile, so daß die Herstellung solcher Rezipientenplatten aufwendiger und damit teurer ist, als ebene Platten.

Aufgabe der vorliegenden Erfindung ist es nun, eine Vorrichtung zu schaffen, welche die Durchbiegung von ebenen Außenwänden an Vakuumbehältern von Bandbeschichtungsanlagen reduziert, daraus resultierende Verschiebungen von an diesen Außenwänden befestigten Bauelementen, wie beispielsweise Führungs- und Umlenkwalzen, vermeidet und einfacher und kostengünstiger auszuführen ist, als bislang bekannte Vorrichtungen.

Diese Aufgabe wird erfindungsgemäß durch die Merkmale des Anspruchs 1 gelöst. Ein Distanzbolzen wird zwischen den Außenwänden der Vakuumkammer, zum Beispiel in der Mitte der Rezipientenplatte, angebracht. Dieser wird auf einen minimalen Abstand zur Rückwand eingerichtet.

Beim Evakuieren des Vakuumkessels wirken nun die Kräfte auf die Rückwand und die Rezipientenplatte über diese Abstützung gegeneinander und verringern so mit Vorteil die Durchbiegung.

In einem Berechnungsmodell ergab sich eine Verminderung der maximalen Durchbiegung von beispielsweise 4 mm auf 0,4 mm, was mit Vorteil eine Reduzierung der Durchbiegung der Rezipientenplatte um 90 % ergibt.

Grundsätzlich sind Durchbiegungsprobleme von Außenwänden an Vakuumbehältern aller Art auf diese Weise zu reduzieren. Bevorzugte Ausführungsformen sind in den anhängigen Ansprüchen 2 bis 12 offenbart.

Die Erfindung läßt verschiedene Ausführungsmöglichkeiten zu; zwei davon sind in den anhängenden Zeichnungen beispielhaft dargestellt, und zwar zeigen:
- Figur 1: ein Wickelsystem für Vakuum-Bandbeschichtungsanlagen gemäß Stand der Technik im Schnitt, wie z.B. in dem Prospekt Nr. 13-140.01 der LEYBOLD-HERAEUS GMBH angegeben,
- Figur 2: ein Wickelsystem gemäß Figur 1 unter Betriebsbedingungen,
- Figur 3: ein Wickelsystem mit einer erfindungsgemäßen Abstützung und
- Figur 4: ein Wickelsystem mit einem in Längsrichtung verstellbaren Distanzstück.

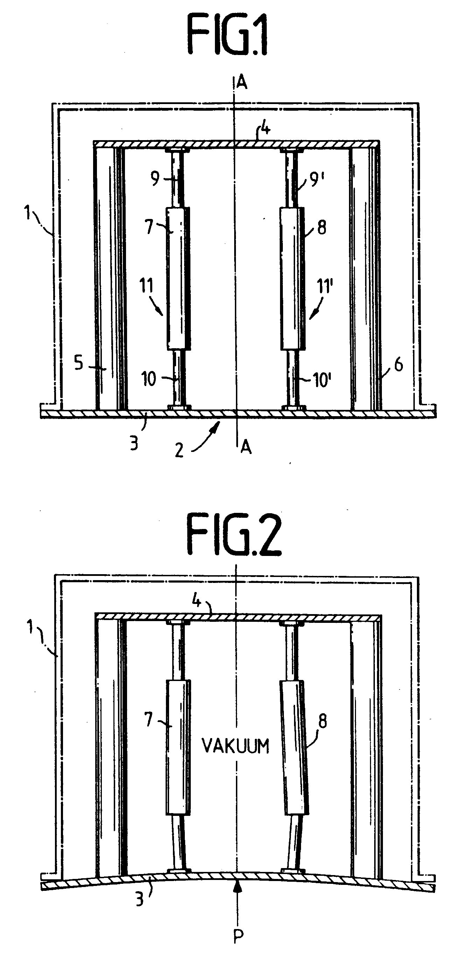

Die strichpunktierten Linien in Figur 1 kennzeichnen einen feststehenden Vakuumkessel 1, die Voll-Linien den beweglichen Teil einer Wickelvorrichtung 2. Diese besteht im einzelnen aus einer Rezipientenplatte 3, welche den Vakuumkessel 1 verschließt, und einer parallel dazu angeordneten Gegenplatte 4. Die Platten 3, 4 sind mittels der beiden Distanzbolzen 5, 6 miteinander verbunden, wobei die Bolzen 5, 6 in radialer Richtung den größtmöglichen Abstand zueinander aufweisen. Zwischen den Platten 3, 4 sind in paralleler Richtung zu den Bolzen 5, 6 die Umlenkwalzen 7, 8 montiert. Diese sind im wesentlichen dreiteilig ausgeführt, nämlich aus zwei kurzen Lagerstummeln 9, 9', 10, 10', die direkt mit den Platten 3, 4 verbunden sind und dem eigentlichen Walzenkörper 11, 11', der zwischen den beiden Lagerstummeln 9, 9', 10, 10' angeordnet ist. Der Kessel 1 und die Wickelvorrichtung 2 sind symmetrisch zur Achse A-A angeordnet.

Unter Betriebsbedingungen (Figur 2) ist der Kessel 1 evakuiert und an der Außenseite des Kessels 1 und der Rezipientenplatte 3 liegt Atmosphärendruck P an. Dies hat zur Folge, daß sich die Rezipientenplatte 3 kalottenförmig zum Innenraum des Kessels 1 hin durchbiegt. Da die Gegenplatte 4 weitgehend frei ist von äußeren Kräften, resultieren daraus Verschiebungen von den, an der Platte 3 befestigten Bauteilen, d.h. die Umlenkwalzen 7, 8 biegen sich, so daß die erforderliche Parallelität der Walzen 7, 8 zueinander nicht mehr gegeben ist.

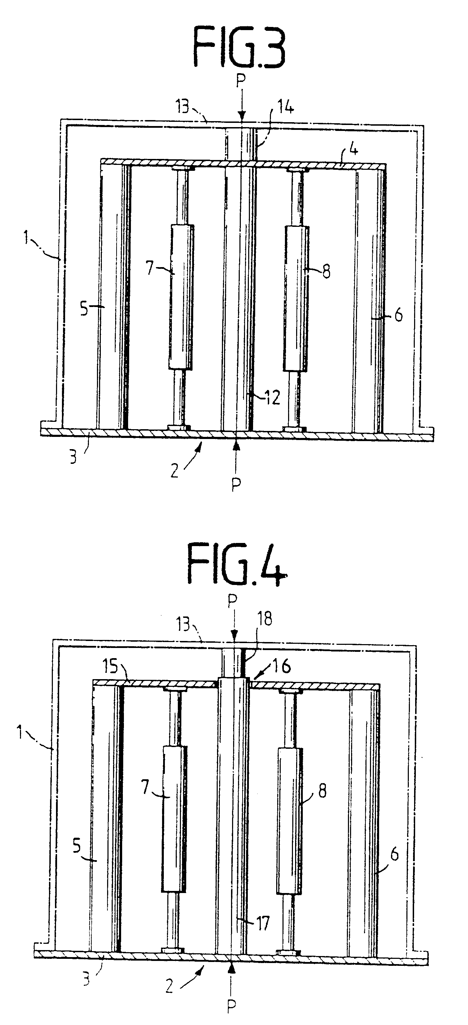

Figur 3 geht im wesentlichen von der Darstellung in Figur 1 aus, ist jedoch erfindungsgemäß erweitert durch einen Distanzbolzen 12, der zwischen Rezipientenplatte 3 und Gegenplatte 4 in der Mitte der Rezipientenplatte 3 und parallel zu den Bolzen 5, 6 angeordnet ist. In axialer Verlängerung des Distanzbolzens 12 ist zwischen der Gegenplatte 4 und der Rückwand 13 des Vakuumkessels 1 ein Druckbolzen 14 vorgesehen, der fest mit der Außenwand 13 verbunden ist. Dieser wird auf einen minimalen Abstand zur Rückseite der Gegenplatte 4 eingerichtet, so daß beim Evakuieren des Kessels 1 die Kräfte, die durch den Atmosphärendruck P auf der Rezipientenplatte 3 und auf der Rückwand 13 lasten, gegeneinander wirken und so die Durchbiegung verringern.

In Figur 4 ist eine alternative Ausführungsform zu Figur 3 dargestellt. Anstelle eines Distanz- und eines Druckbolzens, die sich an einer Gegenplatte abstützen, ist nun eine Gegenplatte 15 mit einer Bohrung 16 versehen, durch die ein Distanzbolzen 17 hindurchgeführt ist. Dieser Bolzen 17 ist an seinem einen Ende mit einem längsverschiebbaren Druckkolben 18 versehen, so daß sich der Bolzen 17 und der Kolben 18 direkt zwischen den beiden Außenwänden 3, 13 abstützen.

### Auflistung der Einzelteile

- 1: Vakuumkessel
- 2: Wickelvorrichtung
- 3: Rezipientenplatte, Außenwand
- 4: Gegenplatte, Zwischenwand
- 5: Distanzbolzen
- 6: Distanzbolzen
- 7: Umlenkwalze
- 8: Umlenkwalze
- 9, 9': Lagerstummel
- 10, 10': Lagerstummel
- 11, 11': Walzenkörper
- 12: Distanzbolzen
- 13: Rückwand, Außenwand
- 14: Druckbolzen
- 15: Gegenplatte
- 16: Bohrung
- 17: Distanzbolzen
- 18: Druckkolben
- A-A: Achse
- P: Atmosphärendruck

## Patentansprüche

1. Vorrichtung zur Reduzierung der Durchbiegung ebener Außenwände (3, 13) an einem Vakuumkessel (1) einer Bandbeschichtungsanlage, die genannte Vorrichtung bestehend aus einer gegenüber dem Vakuumkessel (1) beweglichen Wickelvorrichtung (2), welche aus einer Rezipientenplatte (3), einer Gegenplatte (4) und zwischen diesen beiden Platten (3, 4) abstützenden Umlenkwalzen (7, 8) besteht, wobei unter Betriebsbedingungen einerseits die Rezipientenplatte (3) eine Außenwand des Vakuumkessels (1) bildet und andererseits die Gegenplatte (4) in dem Vakuumkessel (1) zwischen der Rezipientenplatte (3) und einer dieser gegenüberliegenden Außenwand (13) angeordnet ist, **dadurch gekennzeichnet**, daß mindestens ein Distanzstück zwischen der Rezipientenplatte (3) und der gegenüberliegenden Außenwand (13) angeordnet ist.

2. Vorrichtung nach Anspruch 1, **dadurch gekennzeichnet**, daß die Rezipientenplatte (3), die ihr gegenüberliegende Außenwand (13) des Kessels (1) sowie die Gegenplatte (4) jeweils parallel zueinander angeordnet sind.

3. Vorrichtung nach Anspruch 1, **dadurch gekennzeichnet**, daß das Distanzstück als einstückiger oder mehrstückiger Distanzbolzen (12, 17) ausführbar ist.

4. Vorrichtung nach Anspruch 3, **dadurch gekennzeichnet**, daß ein Distanzbolzen (12) zwischen der Außenwand (3) und der gegenüberliegenden Gegenplatte (4) der Wickelvorrichtung (2) angeordnet ist.

5. Vorrichtung nach Anspruch 4, **dadurch gekennzeichnet**, daß der Distanzbolzen (12) fest mit der Außenwand (3) und der Gegenplatte (4) verbunden ist.

6. Vorrichtung nach Anspruch 5, **dadurch gekennzeichnet**, daß in axialer Verlängerung des Distanzbolzens (12) ein Druckbolzen (14) zwischen Gegenplatte (4) und Außenwand (13) angeordnet ist.

7. Vorrichtung nach Anspruch 6, **dadurch gekennzeichnet**, daß der Druckbolzen (14) fest mit der Außenwand (13) verbunden ist.

8. Vorrichtung nach einem oder mehreren der vorherigen Ansprüche, **dadurch gekennzeichnet**, daß der Distanzbolzen (12) in Flächenmitte der Wände (3, 4, 13) angeordnet ist.

9. Vorrichtung nach einem oder mehreren der vorherigen Ansprüche, **dadurch gekennzeichnet**, daß eine Gegenplatte (15) mit mindestens einer Bohrung (16) versehen ist.

10. Vorrichtung nach Anspruch 9, **dadurch gekennzeichnet**, daß mindestens ein Distanzbolzen (17) mit einem längenverschiebbaren Druckkolben (18) versehen ist.

11. Vorrichtung nach Anspruch 9 oder 10, **dadurch gekennzeichnet**, daß der Distanzbolzen (17) durch die Bohrung (16) der Platte (15) hindurchführbar ist.

12. Vorrichtung nach den Ansprüchen 9, 10 oder 11, **dadurch gekennzeichnet**, daß der Bolzen (17) und der Kolben (18) gegen die Außenwände (3, 13) abstützbar sind.

## Claims

1. Device for reducing the deflection of plane outer walls (3, 13) of a vacuum tank (1) of a strip coating plant, said device consisting of a winding device (2) which is moveable in relation to the vacuum tank (1) and which consists of a receiving plate (3), a counterplate (4) and supporting deflection rollers (7, 8) between these two plates (3, 4), whereby, under operational conditions, on the one hand the receiving plate (3) constitutes an outer wall of the vacuum tank (1) and on the other hand the counterplate (4) is arranged in the vacuum tank (1) between the receiving plate (3) and an outer wall (13) located opposite said receiving plate, characterised in that at least one spacer is arranged between the receiving plate (3) and the opposite outer wall (13).

2. Devise according to Claim 1, characterised in that the receiving plate (3), the outer wall (13) of the tank (1) opposite said receiving plate and the counterplate (4) are arranged parallel to one another.

3. Device according to Claim 1, characterised in that the spacer can be constructed as a one-piece or multi-piece spacing bolt (12, 17).

4. Device according to Claim 3, characterised in that a spacing bolt (12) is arranged between the outer wall (3) and the opposite counterplate (4) of the winding device (2).

5. Device according to Claim 4, characterised in that the spacing bolt (12) is rigidly connected to the outer wall (3) and the counterplate (4).

6. Device according to Claim 5, characterised in that in the axial prolongation of the spacing bolt (12) there is arranged a pressure bolt (14) between counterplate (4) and outer wall (13).

7. Device according to Claim 6, characterised in that the pressure bolt (14) is rigidly connected to the outer wall (13).

8. Device according to one or more of the preceding claims, characterised in that the spacing bolt (12) is arranged in the centre of the surfaces of the walls (3, 4, 13).

9. Device according to one or more of the preceding claims, characterised in that a counterplate (15) is provided with at least one bore (16).

10. Device according to Claim 9, characterised in that at least one spacing bolt (17) is provided with a longitudinally displaceable pressure piston (18).

11. Device according to Claim 9 or 10, characterised in that the spacing bolt (17) is capable of being guided through the bore (16) of the plate (15).

12. Device according to Claim 9, 10 or 11, characterised in that the bolt (17) and the piston (18) are capable of being supported against the outer walls (3, 13).

## Revendications

1. Dispositif pour réduire la flèche de parois extérieures planes (3, 13) d'une enceinte à vide (1) appartenant à une installation de revêtement de bandes, le dispositif précité étant composé d'un dispositif d'enroulement (2) mobile par rapport à l'enceinte à vide (1), qui est composé d'une plaque de récipient (3), d'une contre-plaque (4) et de rouleaux de renvoi (7, 8) qui prennent appui entre ces deux plaques (3, 4), et dans lequel, dans les conditions de service, d'une part, la plaque de récipient (3) forme une paroi extérieure de l'enceinte à vide (1) et, d'autre part, la contre-plaque (4) est disposée dans l'enceinte à vide (1), entre la plaque de récipient (3) et une paroi extérieure (13) qui lui est opposée, caractérisé en ce qu'au moins une entretoise est disposée entre la plaque de récipient (3) et la paroi extérieure (13) opposée.

2. Dispositif selon la revendication 1, caractérisé en ce que la plaque de récipient (3), la paroi extérieure (13) de l'enceinte (1) qui lui est opposée, ainsi que la contre-plaque (4) sont disposées parallèlement entre elles.

3. Dispositif selon la revendication 1, caractérisé en ce que l'entretoise peut être réalisée sous la forme d'une tige entretoise (12, 17) en une seule pièce ou en plusieurs pièces.

4. Dispositif selon la revendication 3, caractérisé en ce qu'une tige entretoise (12) est disposée entre la paroi extérieure (3) et la contre-plaque opposée (4) du dispositif d'enroulement (2).

5. Dispositif selon la revendication 4, caractérisé en ce que la tige entretoise (12) est fixée rigidement à la paroi extérieure (3) et à la contre-plaque (4).

6. Dispositif selon la revendication 5, caractérisé en ce qu'une tige de pression (14) est interposée entre la contre-plaque (4) et la paroi extérieure (13), dans le prolongement axial de la tige entretoise (12).

7. Dispositif selon la revendication 6, caractérisé en ce que la tige de pression (14) est reliée rigidement à la paroi extérieure (13).

8. Dispositif selon une ou plusieurs des revendications précédentes, caractérisé en ce que la tige entretoise (12) est disposée au centre de la surface des parois (3, 4, 13).

9. Dispositif selon une ou plusieurs des revendications précédentes, caractérisé en ce qu'une contre-plaque (15) est munie d'au moins un perçage (16).

10. Dispositif selon la revendication 9, caractérisé en ce qu'au moins une tige entretoise (17) est munie d'un piston de pression (18) mobile en translation longitudinale.

11. Dispositif selon la revendication 9 ou 10, caractérisé en ce que la tige entretoise (17) peut être enfilée à travers le perçage (16) de la plaque (15).

12. Dispositif selon les revendications 9, 10 ou 11, caractérisé en ce que la tige (17) et le piston (18) prennent appui contre les parois extérieures (3, 13).
